Europäisches Patentamt

(19) European Patent Office

Office européen des brevets

(11) Publication number : **0 305 172 B1**

(12) **EUROPEAN PATENT SPECIFICATION**

(45) Date of publication of patent specification :
04.01.95 Bulletin 95/01

(51) Int. Cl.$^6$ : **H03J 7/18**

(21) Application number : 88307852.9

(22) Date of filing : 24.08.88

(54) **Radio data system receivers.**

(30) Priority : **24.08.87 GB 8719944**

(43) Date of publication of application :
**01.03.89 Bulletin 89/09**

(45) Publication of the grant of the patent :
**04.01.95 Bulletin 95/01**

(84) Designated Contracting States :
**AT BE CH DE ES FR GR IT LI LU NL SE**

(56) References cited :
**EP-A- 0 115 009**
**EP-A- 0 125 453**
**DE-A- 3 208 760**
**EUROPEAN BROADCASTING UNION, Tech 3244-E, March 1984, pages 1-60, Brussels, BE;"Specifications of the radio data system RDS for VHF/FM sound broadcasting"**

(73) Proprietor : **BRITISH BROADCASTING CORPORATION**
**Broadcasting House**
**London W1A 1AA (GB)**

(72) Inventor : **Parnall, Simon John**
**54 Beckway Road**
**London SW16 4HA (GB)**
Inventor : **Ely, Stephen Robert**
**7 Woodcrest Walk**
**Reigate, Surrey (GB)**
Inventor : **Taylor, Graham**
**22 Grovelands**
**Horley Surrey RG6 9HE (GB)**
Inventor : **Marks, Beverley**
**76 Wessex Gardens**
**Twyford Hertfordshire RG10 0AY (GB)**
Inventor : **Saunders, Mark Stephen**
**19 Gerald's Grove**
**Banstead Surrey SM7 1NE (GB)**

(74) Representative : **Abnett, Richard Charles et al**
**REDDIE & GROSE**
**16 Theobalds Road**
**London WC1X 8PL (GB)**

## Description

The present invention relates to receivers for use in conjunction with radio data system (RDS) transmissions. Although recommendations have finally to be agreed a body of RDS standards is emerging under the auspices of the EBU (European Broadcasting Union). Reference is made in particular to the RDS specification in EBU Doc. Tech. 3244-E.

The object of the present invention is to make it possible for each push-button of an RDS receiver to have associated with it a correctly maintained list of alternative, generically related services, which the user can select by repeated operation of a selected push-button.

German Patent Application DE-A-32 08 760 describes a UHF radio receiver tuner control system. A comparator compares stored information on transmitters that can be received in a certain region and in a certain frequency range with data received on an incoming transmission. The comparator loads a receiver store in response to which the tuner setting is altered.

European Patent Application EP-A-0 115 009 describes a radio or TV receiver with automatic tuning. Push-buttons are used to select desired programmes defined by frequencies entered in respective stores. Each store is preceded by a filter which only passes the reception frequency when the detected PI code corresponds to the programme selected by the associated push button. The system enables simple automatic re-programming of programme frequencies, e.g. for traffic announcements.

According to the present invention there is provided a radio data system receiver as defined in the appended claim 1.

In an RDS system various digital codes are superimposed on the audio programme material including codes which are particularly important in relation to automatic tuning, which is regarded by the EBU as a priority RDS feature. The codes in question are PI - programme identification, AF - alternative frequencies and ON - other networks. In the PI code, bits 1 to 4 identify the country, the UK being code C (hexadecimal). Bits 5 to 8 define the type of area coverage (national, regional, local, etc.). Bits 9 to 16 identify 255 possible programme reference numbers (or programme services), the value 00 being unused.

AF codes identify alternative frequencies on which the same or a related programme may be found and further information is to be found in Doc. Tech. 3244-E, Supplement 1, including two different methods (Method A and Method B) of transmitting AF lists.

ON codes are used to keep up to date the AF and other information for networks other than that to which the receiver is currently tuned, in order that the push buttons shall always be correctly programmed.

It is intended that the allocation of codes corresponding to PI bits 9 to 16 be decided nationally. Neither the listeners nor the designers of RDS receivers need to know precise details of how these codes have been allocated within any given country. Indeed, it is undesirable that the RDS receiver should store any permanent memory information concerning the use of bits 9 to 16 in the PI code because this information will, during the lifetime of the receiver, become out of date as new programme services are introduced and old ones changed or abolished.

At a recent Turin meeting of the EBU Specialist Group R1/RDS several important clarifications of the meaning of the RDS Specification in respect of the PI feature were agreed:

### a. Identical PI codes

Two transmissions may have the same PI code (identical) in all sixteen bits), if and only if, both transmissions are at that moment carrying the same sound programme signal. Thus a receiver, finding two transmissions with the same PI code, can switch as necessary between the two transmissions without disturbing the listener.

### b. PI codes which differ in bits 5 to 8 only

As noted above, networks of transmitters are often split so that, at various times of the day, some transmitters carry different programmes (e.g. programmes of regional or local interest). In such cases, it is helpful if the PI codes of the transmitters in these split networks carry PI codes which differ from each other in bits 5 to 8 (area coverage code) only. It is intended that, when manually set to do so, the RDS receiver should automatically retune to such a regional variant of the selected programme if the selected programme fades.

This concept of generically linked networks is of great importance because it can extend the use of the PI feature beyond the rather narrow confines of national networks.

It was agreed that broadcasters may freely use the twelve available regional area codes R1 to R12 (bits 5 to 8 set in the range 4 to F hex); the correspondence of Codes A to F (hex) with ARI traffic area codes does not prevent the use of these codes in countries which do not use the ARI system or imply definite correspondence between the RDS area code and the ARI area code in those countries which do use the ARI system.

The principle use of the PI code is to establish when comparing transmissions on one or more alternative frequencies, whether or not those transmissions carry the same programme. This is necesssary when exploiting the alternative frequency feature to avoid, in some circumstances, automatically switching to an alternative frequency which happens, in the area in which the receiver is placed, to carry a different programme.

Three cases are envisaged:

1. National networks: transmissions carrying the same network programme all carry the same PI code (identical in all sixteen bits). Since the programme signal carried by all these transmissions is the same, the receiver may automatically switch between any two transmissions bearing the same PI code in order to utilise the best reception in any area.

Transmissions which do not carry the same programme must never use the same PI code, since this could lead to the receiver arbitrarily switching between different programmes.

2. Regional network: where a regional variation of a national network is broadcast, the broadcaster may choose to use a PI code which differs from that of the parent national network only in the four bits of the area code (bits 5 to 8). In this case, these regional variations may appear in the AF list by using Method B defined in Supplement 1 to Doc. Tech. 3244-E, with the frequency pairs relevant to the regional variants transmitted in descending frequency order. In this case the receiver may switch to one of these regional variants only when manually instructed to do so, for example by the listener depressing the relevant preset push-button which was used to select that network.

In the case of regional networks which are split from the national network only at certain times of the day, the broadcaster may choose to switch the PI code so that when that transmitter carries the national programme, it carries the PI code of the national programme so that the receiver can automatially switch to it. Alternatively, the broadcaster may, for simplicity of operation, always identify that transmitter as a regional variant even when it carries the national programme. In that case, of course, the receiver will not automatically retune to that transmitter from the national network.

Some so called networks of local radio (eg BBC Local Radio) may be regarded as a regional network in this way.

3. Local Stations: are defined as stations which broadcast on a single frequency only. In this special case of broadcasts bearing area code "L", the receiver manufacturer may choose to store the frequencies of all receivable local stations against one push-button, such that repeated depression of the push-button will cause the receiver to toggle through the list of stored stations, even though they have completely different PI codes. In this case, the alternative frequency feature may, at the discretion of the broadcaster, be used to give the frequencies of these other local stations in the surrounding area.

It should be noted that the tuning frequency is of special significance, the receiver will not change from the currently selected tuning frequency unless the signal becomes unusable due to low signal strength or multipath. Thus, even if the PI code changes on the tuning frequency, the receiver will remain tuned to that same frequency and accept the new PI code and associated list of alternative frequencies. Furthermore, after the receiver switches to another network to use the Traffic Announcement (TA) feature, it will always return to the original tuning frequency. These features are essential to facilitate the regional network switching case described under (2) above, and to prevent improper operation of the receiver on entering or leaving tunnels in mountainous regions.

When a network splits, the PI code of the transmitters carrying the regional programme must necessarily change from that identifying the national programme. A receiver tuned to that transmitter will find that the PI code received from the tuning frequency suddenly changes.

The expected reaction of the receiver in this case is that it should not retune (assuming that the field strength of the received signal is still adequate) but should stay tuned to the same frequency. The receiver should now use the new PI code as a reference and accept alternative frequencies for that new PI code only.

At first sight this might seem to be the opposite of what is expected of RDS in that the receiver might be expected to continue to search for the programme originally selected by the listener even if it is available on MF or LF only. Further thought, however, shows that if the receiver did switch when the PI code is changed by the broadcaster then the results could be very frustrating for the listener. Consider, for example, the listener who wants to hear the regional programme and has tuned to the correct frequency a few minutes early. If the receiver retunes when the PI code changes then he would suddenly lose the desired programme.

Application of the AF feature to Generically Linked Networks

Method B for the Transmission of AF codes makes provision for the transmission of AF codes of generically linked networks within Type 0 groups. Thus if the frequency pair f1 and f2 is such that f1> f2 and f1 is the first transmitted frequency code in a block then f2 is the frequency of a transmitter which carries a generically linked (but not identical) programme. It is expected that the receiver will automatically switch to this programme only if manually enabled to do so by the listener.

If this method is used, or if Method A is used (which has no provision for this feature) then it is important that the broadcaster does not include codes in the AF list which are not valid alternatives since the receiver will switch to these alternatives and then give an undesired programme until the PI code has been evaluated (perhaps a fifth of a second or more).

Application of the ON feature to Generically Linked Networks

The RDS Specification allows cross-referencing of up to eight Other Networks in Type 3 Groups. Each Other Network is labelled by its PI code and it is intended that, if for example button 2 of the receiver is assigned to PI code C402 then the AFs in the ON list associated with C402 will be stored against button 2 and so updated even while the receiver is tuned to another network.

The limitation of eight Other Networks was found to be unsatisfactory in the UK, where in some areas more than twelve different BBC programmes at usable field strength may be found. However, by extending the concept of generically linked PI codes to ON information it becomes possible to group all the stations in the generically linked network together under one address label in the Type 3 Groups. The AF codes for a generically linked network can then be delivered to the receiver for storage against a single push-button. Indeed, if so programmed, generically related programmes associated with the presently selected service may also receive their information in this way. There is then no need to use the Method B descending frequency method of AF codes to send this information.

It is the intention of the British Broadcasting Corporation (BBC) to use generic sets for all its transmissions, this is very largely due to the flexibility that this feature affords, but also because all our services are, to some extent, regional.

The BBC will employ the following coding rules:-

Bits 1 to 4

Always set to "C" - UK country code.

Bits 5 to 8

All services are assigned codes in the range "4" to "F". Local radio stations will be assigned a number to provide an adequate distance between stations carrying the same PI code. For UK services, the code chosen will reflect the degree of deviation from the main service, the lower the number, the more pure the service. To give an example, Radio Two in its pure form is assigned the code C402, but when sharing a joint network with Radio One, is given the code C502.

Bits 9 to 12

Define the service coverage. UK services are assigned "0", National services "1", and Local services "2". "3" is reserved by the BBC for future use. Codes "4" to "F" are assigned to other UK broadcasters.

Bits 13 to 16

Define the basic service. For UK services (those assigned "0" for bits 9 to 12) all stations radiating derivatives of Radio 2 will be assigned a "2" for bits 13 to 16, and similarly for other networks. National services will each be assigned a unique code. Local services will be assigned only one code - "0", to give them membership of the same generic set.

Examples

Some examples of BBC Radio Data PI codes:-
Radio Two            C402
Radio Two/One        C502/C501 (Split service)
Radio Four           C404

**4**

Radio Cymru     C411
Radio Leeds     C920
Radio Devon     C620

It is assumed that the receiver will be equipped with a number of push-buttons, rather akin to the preset tuning buttons found on conventional receivers. Associated with each button will be at least one PI code. To make proper use of changing PI codes and generic codes, the set will require two PI stores per button: one "read-only" and one "read/write", and two lists of frequencies per button; one for alternative frequencies and one for alternative services.

When the user switches on his set for the first time, he will go through a cold-start procedure, a process whereby the PI'S of desired stations are loaded into the "read-only" stores.

Behind each button will be a list of frequencies where the same, or alternative services may be found. To understand how this works an example will be used. A hypothetical receiver has four buttons, the "read-only" PI's are as follows:

| Button | 1 | 2 | 3 | 4 |
|--------|------|------|------|------|
| PI | C401 | C502 | C404 | C620 |

The cold start procedure loaded Radio One on button 1, Radio 2/1 on button 2, Radio Four on button 3, and Radio Devon on button 4.

Button 3 is pressed, giving Radio Four, Radio Data transmitted on this service updates the Alternative Frequency list for this button. It also sends ON information applicable to other services in the area, PI'S and frequency lists. The receiver matches each received PI against its list of "read-only" PI's. If the code matches precisely, the AF list for that button is updated. If a generic match is found, then the button's alternative service list is updated. If no match is found, the particular ON reference is ignored.

At a certain time, the Radio Four transmitter radiates the following ON references:-
C401 - Radio One
C502 - Radio Two/one (Radio Two at present)
C403 - Radio Three
C620 - Radio Devon
C520 - Radio Cornwall

Since the receiver is not set up to load information about CnO3, where n is the generic selector "4" to "F", the Radio Three information is ignored. The Radio Cornwall reference matches the generic code of button 4, and is loaded as an alternative service. The ON information is loaded into the AF list of button 4.

If the user presses button 4, he will receive Radio Devon. If he presses the button again, he will select the first alternative service - Radio Cornwall. If other ON references had matched the generic code, then they would also be stacked behind the button, and would be accessed by subsequent button presses. The decision as to which station is first selected may be by signal strength.

Thus, use of the generic feature allows the listener to have on each button exactly what he wants, in this case BBC Local Radio on button 4. This he will get wherever he travels. As he leaves the service area of one local radio station, he presses the button, and leaps to the next.

The listener has programmed his set with C502 in the "read-only" memory of button 2, he presses this button and receives Radio 2/1, this service is currently transmitting Radio Two. However, he is in an area where Radio One takes over the service at 10 pm. When this happens the PI changes from C502 to C501. The change in PI changes the "read/write" PI but not the "read-only" PI. It now becomes apparent why two stores are necessary. The "read/write" PI governs the match used to load the AF list against a button, and the "read-only" PI governs the match used to load the alternative services. By electing to stay with the PI change when it happened, the user has effectively decided to stay with Radio One, and can do so, because the loading of the AF list is governed by the new PI. However, the alternative service list will be updated according to the "read-only" PI code, and will therefore give any references to Radio Two as soon as they are available, he may then change to Radio Two by pressing button 2 again.

The use of two PI stores for each button achieves two things. Firstly, it allows the receiver to follow any changes in PI that are received, regional opt-outs etc; and secondly, it ensures that the receiver is never locked out of the service that the user has programmed against the button. If the dual store feature had not been utilised on the above example, when the PI changed from C502 to C501, the receiver would be effectively locked out from reception of Radio Two, until such time as the PI code reverted, or the receiver was switched off and on again.

In fact, the above example demonstrates a lock-out problem which might also occur under different circumstances. A single-store receiver tuned to a given transmission will reload its store with the PI of a co-channel station if the signal from the desired station is lost - for examples in a short tunnel. The AF list will then be updated, and a switch may be made to a local transmitter of higher power. Upon leaving the tunnel, the strong local undesired transmitter holds the receiver, because the PI of the button has been changed. The listener has no way of returning to the service that he wants. A dual-store receiver would return at the press of a button.

The "read-only" store is not necessarily "read only" in the sense of an EPROM or fixed ROM. It is essentially read-only in that it holds PI codes unchanged during normal operation although these codes may be changed when it is necessary to re-programme the receiver to match changed user tastes or changes in broadcast programmes.

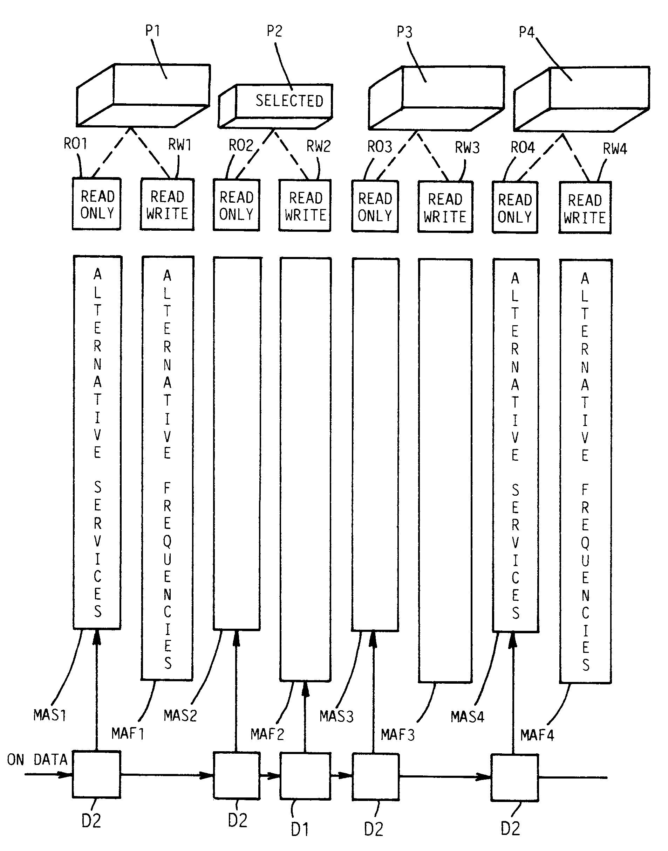

The sole Figure of the accompanying drawing is a schematic diagram illustrating the operation of an embodiment of the invention. It will be appreciated that the invention can be implemented largely in software terms (apart from the provision of the read/write memory for PI codes) and for this reason detailed circuitry is not shown.

In the drawing just four push buttons (or equivalent selection devices) are denoted P1 to P4; in practice more than four will almost certainly be provided. Associated with these buttons are read only PI code stores RO1 to RO4 which are provided in accordance with conventional technology. They are read-only in normal operation but the stored code can be altered in a manual selection operation when the user decides what programmes he wishes to be associated with the buttons P1 to P4. Also associated with the buttons are read/write stores RW1 to RW4 which store PI codes capable of being read and written by the controlling software.

Associated with each of the stores RO1 to RO4 and RW1 to RW4 there are memory areas MAS1 to MAS4 and MAF1 to MAF4. The memory areas MAS1 to MAS4 correspond to the read-only stores and store lists of alternative services corresponding to the buttons P1 to P4 respectively. The memory areas MAF1 to MAF4 correspond to the read-write stores and store lists of alternative frequencies corresponding to the buttons P1 to P4 respectively.

The drawing also illustrates the data flow whereby the lists can be updated when it is the button P2 which is currently selected. The incoming ON data is shown passing through a series of decision blocks. Decision block D1 compares each PI code with the PI code stored in read-write store RW2 (corresponding to button P2). If there is an exact match the alternative frequencies list MAF2 is updated. Decision blocks D2 compare each PI code with the PI code stored in the corresponding read-only store RO1-RO4. If there is a generic match the corresponding alternative services list MAS1 - MAS4 is updated.

Whenever the PI code pertaining to the currently selected programme changes, the new PI code is written into the read-write store RW2.

## Claims

1. A radio data system receiver comprising a plurality of programme selection elements (P1-P4), a plurality of first storage means (RO1-RO4) associated with the selection elements respectively for storing programme identification (PI) codes programmed into the receiver, means (D1) responsive to RDS data in received transmissions to maintain lists of alternative frequencies (MAF2) for received transmissions, means (D2) responsive to RDS data in received transmissions to maintain lists of alternative services (MAS1-MAS4) respectively selectable by operation of the selection element corresponding to the transmission being received (P2) or of other selection elements (P1,P3,P4) corresponding to other networks, and a plurality of read-write storage means (RW1-RW4) associated with the selection elements respectively and arranged to store any changed PI code associated with the transmission being received, wherein the updating of the lists of alternative services selectable by operation of the selection elements is controlled by the PI code stored in the first storage means, whereas the updating of the alternative frequencies list for the transmission being received is controlled by the PI codes stored in the associated read-write storage means.

2. A radio data system receiver according to claim 1, wherein an alternative services list is updated when a PI code in received RDS data matches generically that PI code stored in the first storage means which corresponds to the said list, whereas an alternative frequencies list is updated when a PI code in received RDS data exhibits an exact match with the PI code stored in the read-write storage means corresponding to the said alternative frequencies list.

3. A radio data system receiver according to claim 1 or 2, wherein repeated operations of the same selection element select in turn the services stored in the list of alternative services corresponding to that element.

4. A radio data system receiver according to claim 1, 2 or 3, wherein the receiver selects an alternative frequency from the alternative frequencies list pertaining to the currently selected service only when the received signal ceases to satisfy predetermined criteria.

**Patentansprüche**

1. Empfänger für RDS, mit mehreren Programmwählelementen (P1-P4), mehreren ersten Speichermitteln (RO1-RO4), die jeweils mit Wählelementen zum Speichern von Programmidentifikations-(PI)-Codes verbunden sind, die in den Empfänger einprogrammiert sind, Mitteln (D1), die in Abhängigkeit von RDS-Daten in empfangenen Sendungen Listen alternativer Frequenzen (MAF2) für empfangene Sendungen aufrechterhalten, Mitteln (D2), die in Abhängigkeit von RDS-Daten in empfangenen Sendungen Listen alternativer Dienstleistungen (MAS1-MAS4) aufrechterhalten, die jeweils durch Betätigung des der empfangenen (P2) Sendung entsprechenden Wählelements oder anderer Wählelemente (P1, P3, P4), die anderen Netzen entsprechen, wählbar sind, und mehreren Schreib-Lese-Speichermitteln (RW1-RW4), die jeweils mit den Wählelementen verbunden und so angeordnet sind, daß sie irgendeinen geänderten PI-Code speichern, der der empfangenen Sendung zugeordnet ist, wobei das Erneuern der Listen alternativer Dienstleistungen, die durch Betätigung der Wählelemente wählbar sind, durch den in dem ersten Speichermittel gespeicherten PI-Code steuerbar ist, während das Aktualisieren der Liste alternativer Frequenzen für die empfangene Sendung durch die in den angeschlossenen Lese-Schreib-Speichermitteln gespeicherten PI-Codes gesteuert wird.

2. Empfänger nach Anspruch 1, bei dem eine Liste alternativer Dienstleitstungen aktualisiert wird, wenn ein PI-Code in empfangenen RDS-Daten weitgehend mit demjenigen PI-Code übereinstimmt, der in dem ersten Speichermittel gespeichert ist, das der erwähnten Liste entspricht, wohingegen eine Liste alternativer Frequenzen aktualisiert wird, wenn ein PI-Code in empfangenen RDS-Daten eine genaue Übereinstimmung mit dem PI-Code aufweist, der in dem Lese-Schreib-Mittel gespeichert ist, das der erwähnten Liste alternativer Frequenzen entspricht.

3. Empfänger nach Anspruch 1 oder 2, bei dem wiederholte Betätigungen des gleichen Wählelements der Reihe nach die in der Liste alternativer Dienstleistungen gespeicherten Dienstleistungen wählen, die diesem Element entsprechen.

4. Empfänger nach Anspruch 1, 2 oder 3, bei dem der Empfänger eine alternative Frequenz aus der Liste alternativer Frequenzen, die der augenblicklich gewählten Dienstleistung zugeordnet ist, nur dann auswählt, wenn das empfangene Signal aufhört, vorbestimmten Kriterien zu genügen.

**Revendications**

1. Récepteur de système de données radio comprenant une pluralité d'éléments de sélection de programme (P1-P4), une pluralité de premiers moyens de stockage (R01-R04) associés respectivement aux éléments de sélection pour stocker des codes d'identification de programme (PI) programmés dans le récepteur, un moyen (D1) sensible à des données RDS lors d'émissions reçues pour maintenir des listes de fréquences alternatives (MAF2) pour des émissions reçues, un moyen (D2) sensible à des données RDS lors d'émissions reçues pour maintenir des listes de dessertes alternatives (MAS1-MAS4) pouvant être sélectionnées respectivement par l'activation de l'élément de sélection correspondant à l'émission qui est en train d'être reçue (P2) ou d'autres éléments de sélection (P1, P3, P4) correspondant à d'autres réseaux et une pluralité de moyens de stockage de lecture/écriture (RW1-RW4) associés respectivement aux éléments de sélection et agencés pour stocker n'importe quel code PI modifié associé à l'émission qui est en train d'être reçue, dans lequel la mise à jour des listes de dessertes alternatives qui peuvent être sélectionnées par l'activation des éléments de sélection est commandée par le code PI stocké dans le premier moyen de stockage tandis que la mise à jour de la liste de fréquences alternatives pour l'émission qui est en train d'être reçue est commandée par les codes PI stockés dans le moyen de stockage de lecture/écriture associé.

**2.** Récepteur de système de données radio selon la revendication 1, dans lequel une liste de dessertes alternatives est mise à jour lorsqu'un code PI contenu dans des données RDS reçues correspond de façon générale au code PI stocké dans le premier moyen de stockage qui correspond à ladite liste tandis qu'une liste de fréquences alternatives est mise à jour lorsqu'un code PI contenu dans des données RDS reçues présente une correspondance exacte avec le code PI stocké dans le moyen de stockage de lecture/écriture correspondant à ladite liste de fréquences alternatives.

**3.** Récepteur de système de données radio selon la revendication 1 ou 2, dans lequel des activations répétées du même élément de sélection permettent de sélectionner tour à tour les dessertes stockées dans la liste de dessertes alternatives correspondant à cet élément.

**4.** Récepteur de système de données radio selon la revendication 1, 2 ou 3, dans lequel le récepteur sélectionne une fréquence alternative parmi la liste de fréquences alternatives concernant la desserte présentement sélectionnée seulement lorsque le signal reçu cesse de satisfaire des critères prédéterminés.